# EUROPÄISCHE PATENTSCHRIFT

(11) **EP 1 383 368 B1**
(45) Veröffentlichungstag und Bekanntmachung des Hinweises auf die Patenterteilung: **29.12.2010**
(21) Anmeldenummer: 03012763.3
(22) Anmeldetag: 05.06.2003
(51) Int. Cl.: H05K 7/14

(54) **Modul für ein elektrisches Gerät, insbesondere Feldbusmodul**
Module for electronic device, especially field bus module
Module pour un appareil électronique, module avec bus de secteur en particulier

(30) Priorität: 19.07.2002 DE 20211002 U
(43) Veröffentlichungstag der Anmeldung: 21.01.2004
(73) Patentinhaber: Weidmüller Interface GmbH & Co. KG, 32758 Detmold (DE)
(72) Erfinder: Höing, Michael, 32657 Lemgo (DE); Wünsche, Thorsten, 33818 Leopoldshöhe (DE); Hanning, Walter, 32758 Detmold (DE)
(74) Vertreter: Specht, Peter

(56) Entgegenhaltungen:
- WO-A-00/62376
- WO-A-97/40550
- DE-A1- 2 710 211
- DE-A1- 3 740 290
- DE-A1- 10 006 879
- DE-A1- 19 616 551
- DE-U1- 20 102 038
- DE-U1- 29 919 901

## Beschreibung

Die Erfindung betrifft ein Modul für ein elektrisches Gerät, insbesondere ein Feldbusmodul.

Aus der DE 37 40 290 ist es bekannt, Bus-Sockelmodule vorzusehen, welche auf einer Tragschiene aneinandergereiht werden und in etwa ein stufenförmiges Profil aufweisen. Auf diese werden dann Gehäuse mit einer Elektronik und externen Anschlüssen zu Aktoren, Sensoren und. dgl. aufgerastet.

Aus der WO 00/62376 ist ein Feldbusmodul mit einer Anschlusseinheit und einem auf die Anschlusseinheit aufsetzbares Ein-/Ausgabemodul mit steckbarer Elektronik und einem Elektronikgehäuse bekannt, welches sich für den Einsatzzweck des Aufrastens auf eine Tragschiene ebenfalls bewährt hat.

Es besteht aber auch der Bedarf danach, das hier gezeigte elektrische Gerät bzw. das Feldbusmodul und auch zugehörige Module für das Gateway oder Einspeisegerät derart auszubilden, daß sie und das aus ihnen zusammensetzbare Gerät - eine Station - besonders gegen das Eindringen von Feuchtigkeit geschützt sind. Insbesondere soll ein Schutz nach der Norm EP 67 gegen das Eindringen von Wasser gegeben sein.

Die Erfindung hat die Aufgabe, ein Modul zu schaffen, welches diesen Anforderungen genügt.

Die Erfindung löst diese Aufgabe durch den Gegenstand des Anspruches 1.

Danach weist das Modul folgende Modulgruppen auf:
- eine Grundmoduleinheit zum Aufsetzen auf eine Unterlage wie eine Maschine oder dgl.;
- eine auf die Grundmoduleinheit aufsetzbare Anschlusseinheit;
- vorzugsweise ein auf die Anschlusseinheit aufsetzbares Ein-/Ausgabemodul,
- wobei die Grundmoduleinheit breiter ist als die Anschlusseinheit und an einer Seitenkante der Busgehäuse einen Vorsprung und auf der gegenüberliegende Seitenkante der Busgehäuse eine entsprechend ausgeformte Ausnehmung aufweisen, welche miteinander korrespondieren und abgedichtet beim Aneinanderreihen mehrerer Busgehäuse zusammensteckbar sind,
- wobei die Grundmoduleinheit das Busgehäuse nach Art einer Grundplatte, Buskontakte und eine Busabdeckung zur Abdeckung der Buskontakte aufweist, die vollständig mit einer dichtenden Vergussmasse abgedeckt ist, um das Eindringen von Feuchtigkeit in den Kontaktbereich zu verhindern.

Der besondere Vorteil der Erfindung liegt darin, daß mit den Grundmoduleinheiten zunächst eine in sich stabile Gerätebasis auf einer Maschine herstellbar ist, wobei die Grundmoduleinheiten jeweils für sich und auch gegeneinander sicher abgedichtet sind, ohne daß Anschlüsse zwischen den Grundmoduleinheiten einen Angriffspunkt für eindringendes Wasser bilden könnten. Derart ist sogar die Schutzklasse IP67 realisierbar.

Vorzugsweise ist zumindest eine Reihe der Kontaktbohrungen von einer Nut umgeben, in welche eine Dichtraupe zur Abdichtung gegen ein benachbartes Busgehäuse einbringbar ist, wobei in die Dichtraupe der Nut eine Gegenkontur eines benachbarten Busgehäuses eingreift. Mit dieser Maßnahme wird die Dichtwirkung deutlich erhöht.

Nach einer weiteren vorteilhaften Variante schließt ein mit Vergussmasse vergossener Dichtrahmen die Anschlusseinheit vorteilhaft dichtend nach unten hin zur Grundmoduleinheit hin ab, welchen Kontaktstifte durchsetzen. Der Dichtrahmen ermöglicht in einfacher konstruktiver Weise auch eine wasserdichte Auslegung der Anschlusseinheit und erleichtert deren Vergießen mit dichtender Vergussmasse.

Weitere vorteilhafte Ausgestaltungen der Erfindung sind den übrigen Unteransprüchen zu entnehmen.

Nachfolgend wird die Erfindung unter Bezug auf die Zeichnung näher erläutert. Es zeigt:
- Fig. la-f: aufeinanderfolgende Montageschritte bei der Montage bzw. beim Zu- sammenstellen eines elektrischen Gerätes;
- Fig. 2: eine Sprengansicht eines Feldbusmoduls;
- Fig. 3a,b: das Zusammensetzen einer Grundmoduleinheit und einer Anschlußein- heit;
- Fig. 4a-j: verschiedene Herstellungs- und Montageschritte von Bestandteilen eines Feldbusmoduls.

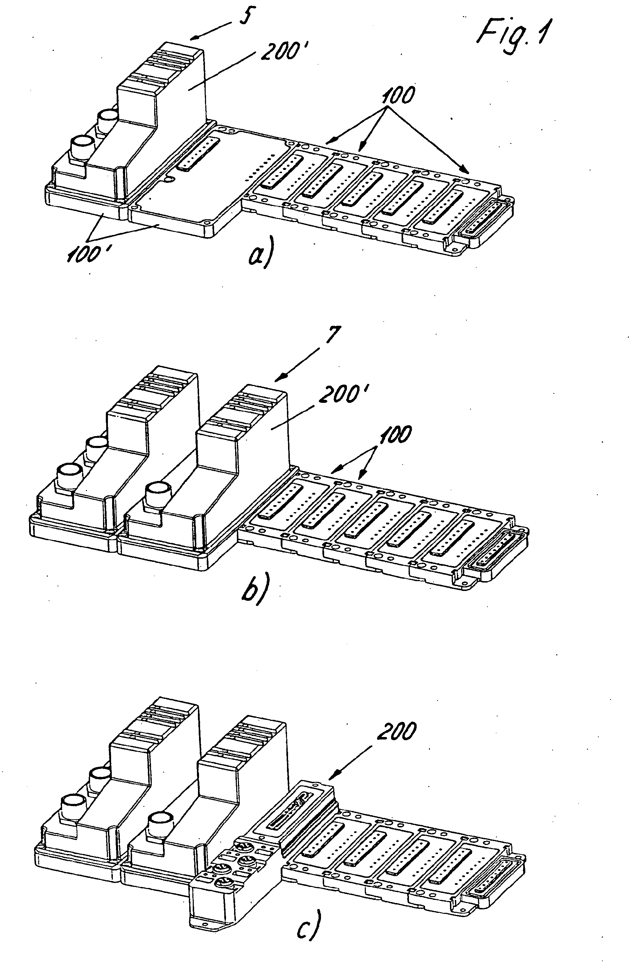

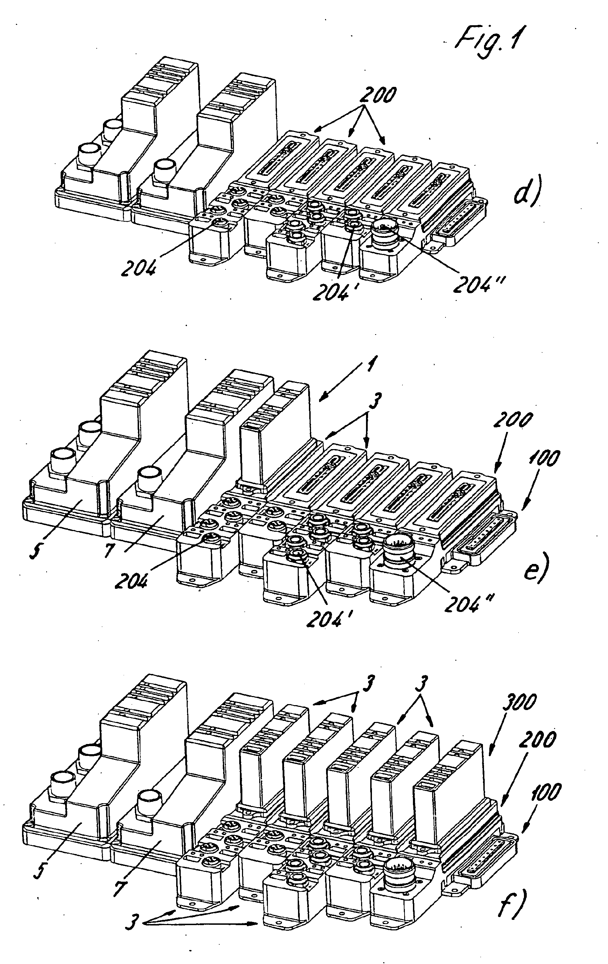

Fig. 1 zeigt die Montage bzw. das Zusammenstellen eines elektrischen Gerätes 1 in aufeinanderfolgenden Schritten, welches nach Fig. 1e aus einer Aneinanderreihung scheibenartiger Feldbusmodule 3 besteht, die an ein Gateway 5, welches mit einer übergeordneten Steuerung verbunden ist - und an ein Einspeisemodul 7 - z.B. für Versorgungsspannungen +, -, PE - angereiht sind.

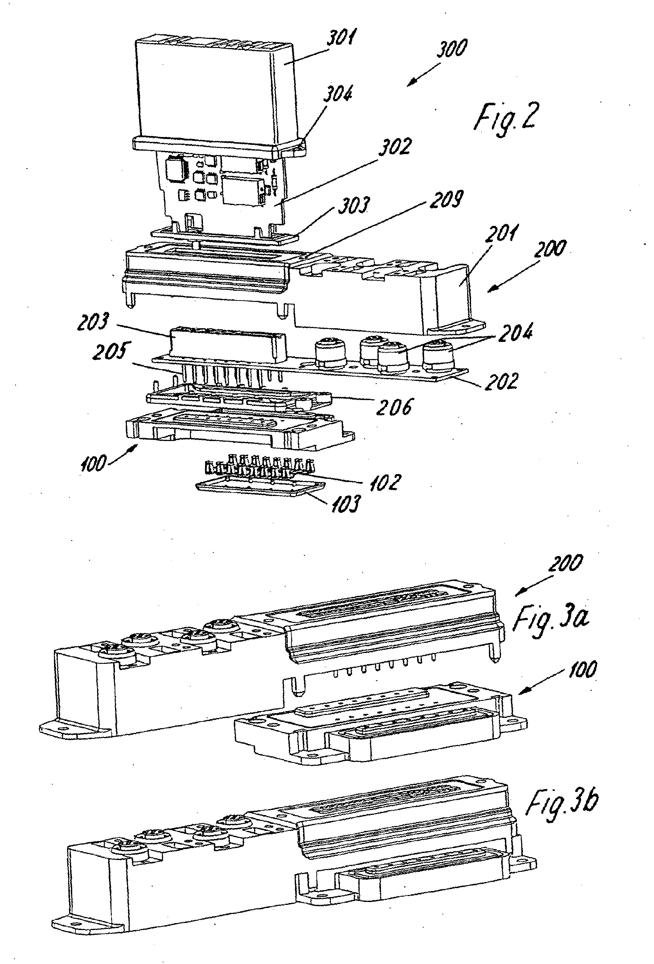

Jedes Feldbusmodul 3 des modularen Feldbus-I/O-Systems (A-L) besteht - wie aus Fig. 3 ersichtlich - aus drei kompletten Modul-Untergruppen:
a) einer Backplane - auch Grundmoduleinheit 100 genannt - mit den Elementen 101, 102, 103;
b) der Terminalbase - auch Anschlusseinheit 200 genannt - mit den Elementen 201, 202, 203, 204, 205, 206; und
c) dem Modul-I/O - auch Ein-/Ausgabemodul 300 genannt - mit den Elementen 301, 302, 303.

Das Gateway 5 und das Einspeisemodul 7 weisen dagegen lediglich jeweils eine Grundmoduleinheit 100' und eine Anschlusseinheit 200' auf, wobei letztere hier z.B. für den Anschluss von Leitungen zu einer übergeordneten Steuerung und/oder zur Spannungsversorgung der Station bzw. des Gerätes dient.

Die Grundmoduleinheiten 100 weisen in ihrer Seitenansicht jeweils eine Art Stufenprofil auf, mit dessen Hilfe sie problemlos aneinanderreihbar sind. Die Grundmoduleinheiten 100' des Gateways und des Einspeisemoduls weisen jeweils eine größere Grundfläche auf als die Grundmoduleinheiten 100 der Feldbusmodule 3, sie sind aber im Verbindungsbereich kompatibel zu den Grundmoduleinheiten 100 der Feldbusmodule und somit an diese anreihbar.

Mit diesem Grundaufbau können verschiedenste Varianten von Feldbusmodulen 1 realisiert werden, welche sich beispielsweise hinsichtlich des Anzahl und Art ihrer Anschlüsse 204, 204', 204" - z.B. M12 Stecker, M24 Stecker oder dgl. - zum Anschluss externer elektrischer Geräte wie Aktoren oder Sensoren unterscheiden können. Die Terminalbase 200 ist somit hinsichtlich dieser Elemente variabel gestaltbar.

Zunächst werden die Anschlusseinheiten 100' und 100 aneinandergereiht (Fig. 1a). Dann werden die Anschlusseinheiten 200' des Gateways und des Einspeisemoduls aufgesetzt (Fig. 1a, b) und dann die Feldbusmodule nach und nach vervollständigt, indem zunächst deren Anschlusseinheiten 200 und dann die Ein-/Ausgabemodule 300 aufgesetzt werden.

Auf verschieden ausgelegten Grundmoduleinheiten 100 können ferner auch die Gateways 5, die Einspeisemodule 7 und dgl. aufgebaut werden.

Des weiteren gibt es eine Vielzahl an verschiedenen Feldbus I/O Modulen. Dieses Feldbus I/O System ist für IP67(DIN 40050, IEC 529) geeignet.

Das Ein-/Ausgabemodul 300 weist nach Fig. 2 eine Abdeckung 301(Modul-I/0-Cover), eine Elektronik(-Leiterplatte) 302 (Modul-I/O-PCB) und eine Basiseinheit 303 (Modul-I/O-Base) zur Aufnahme der Elektronikleiterplatte 302 auf.

Die Anschlusseinheit 200 besteht aus einem in Draufsicht reckeckigen Anschlussgehäuse 201, das eine Anschluss-Leiterplatte 202 aufnimmt, auf welcher ein Steckverbinder 203 zur Kontaktierung der Elektronikleiterplatte 302, und die Anschlussstecker 204 zum Anschluss externer Geräte wie Aktoren oder Sensoren angeordnet sind. Auf der dem Steckverbinder 203 gegenüberliegenden Seite der Anschluss-Leiterplatte 302 sind Kontaktstifte 205 ausgebildet, welche in Einbauposition nach unten hin in Richtung der Grundmoduleinheit 100 vorstehen. Ein Dichtrahmen 206 schließt die Anschlusseinheit dichtend nach unten hin zur Grundmoduleinheit 100 hin ab.

Wesentliche Elemente der Grundmoduleinheit 100 sind ein Busgehäuse nach Art einer im wesentlichen in Draufsicht rechteckigen Grundplatte 101 (Backplane genannt) mit abgerundeten Ecken, Buskontakte 102 im Busgehäuse 101 und eine Busabdeckung 103 zur Abdeckung der Buskontakte 102 am/im Busgehäuse 102. Das Busgehäuse ist breiter als das Anschlussgehäuse 201 aber hier nur etwa halb so lang.

Das Busgehäuse 102 wird auf die Maschine geschraubt, wobei kleinere Unebenheiten auf der Maschine ausgeglichen werden und so eine saubere Ebene zur Abdichtung der Anschlusseinheiten 200 entsteht.

Die Grundmoduleinheiten 100 werden dabei wie folgt hergestellt:

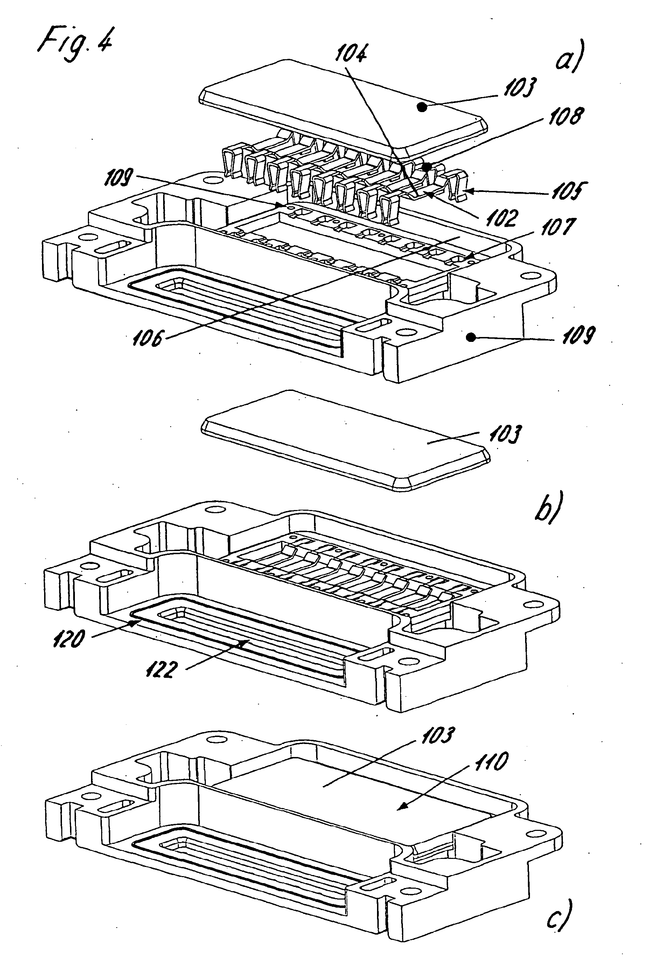

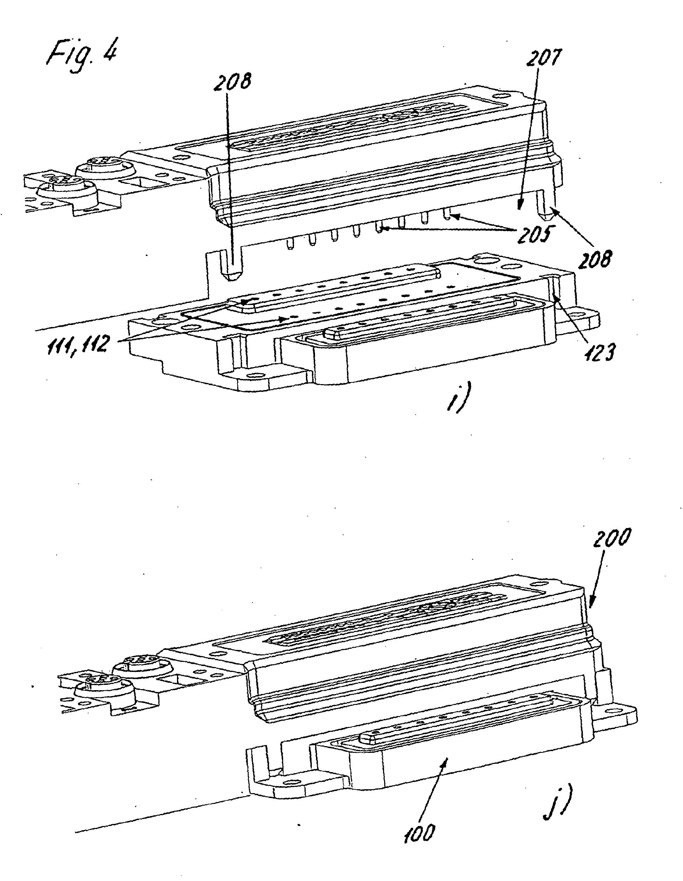

Die Busgehäuse 101 werden nach Fig. 4a mit Buskontakten 102 bestückt, welche einen Stromschienenabschnitt 104 und senkrecht von diesen nach oben abstehende Kontakttulpen oder -federn 105 aufweisen.

Die Buskontakte 102 werden in eine Ausnehmung 106 im Busgehäuse 101 eingesetzt, wobei die Kontakttulpen 105 in Taschen 107 in der Ausnehmung 106 tauchen und bis zu den Auflageflächen 108 der Buskontakte 102 eingeschoben werden.

Die Kontaktfedern 105 der Buskontakte 102 dienen zum Kontaktieren der Kontaktstifte 205 der Anschlusseinheit 200.

Nun wird gem. Fig. 4b die Busabdeckung 103 (Cover) über die Buskontakte 102 gedrückt, wobei Stifte (hier nicht zu erkennen) auf der Unterseite der Busabdeckung 103 in dafür vorgesehene Bohrungen 109 des Busgehäuses 101 tauchen und dort festgeklemmt werden.

Die Busabdeckung 103 dient zum Schutz der Buskontakte 102 und verhindert, daß Vergussmasse in den Kontaktbereich laufen kann.

Der Füllbereich 110 der Ausnehmung 106 um die Busabdeckung 103 wird gem. Fig. 4c vollständig mit einer dichtenden Vergussmasse befüllt, um das Eindringen von Wasser in den Kontaktbereich zu verhindern (nicht dargestellt).

Die Busabdeckung 103 befindet sich an der Unterseite der Busgehäuse 101, welche beispielsweise auf einer Maschine aufliegt.

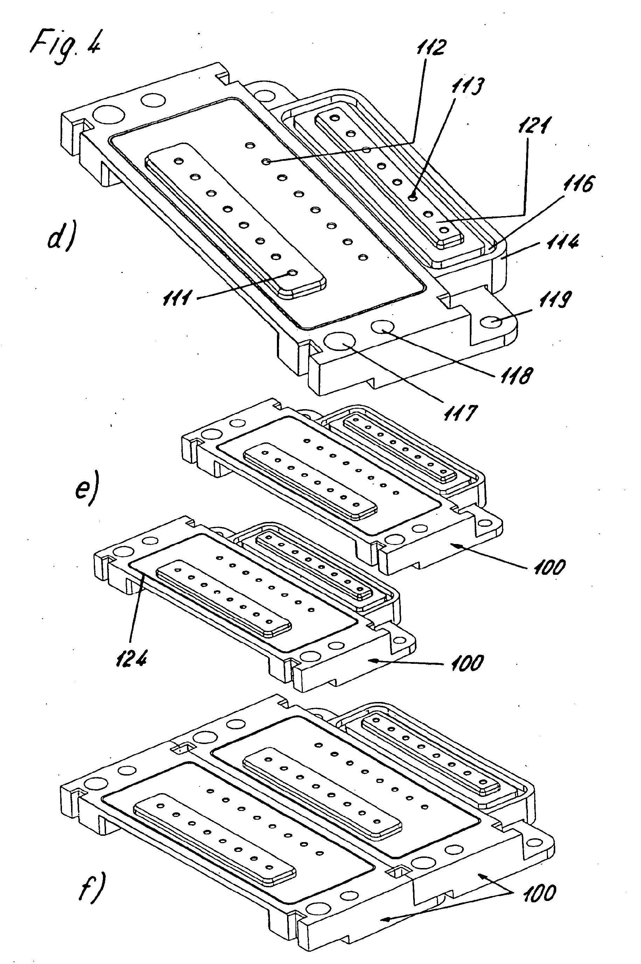

An der gegenüberliegenden Seite der Busgehäuse 101 sind gem. Fig. 4d drei parallel zueinander ausgerichtete Reihen von Kontaktbohrungen 111, 112, 113 ausgebildet.

Unterhalb der Kontaktbohrungen 112 und 113 liegen die Federkontakte 105 der Buskontakte 102.

Die Kontaktbohrungen 111 bis 113 dienen zum Eingriff der zwei Reihen Kontaktstifte 205 der Anschlusseinheit 200. Die Buskontakte 102 ermöglichen dabei die Weiterleitung eines internen Busleiters von Busgehäuse 101 zu Busgehäuse 10 bzw. von Modul zu Modul.

Die Busgehäuse 101 sind derart ausgelegt, daß jeweils ein erstes Busgehäuse 101 stufenartig in ein benachbartes anzureihendes Busgehäuse 101 eingreift (Fig. 4e und f).

Hierzu weisen sie jeweils an ihrer einen Seitenkante einen Vorsprung 114 und auf ihrer gegenüberliegende Seitenkante eine entsprechend ausgeformte Ausnehmung 115 auf, welche miteinander korrespondieren und abgedichtet beim Aneinanderreihen mehrerer Busgehäuse 101 zusammensteckbar sind. Am Vorsprung 114 ist eine die Bohrungen 113 umgebende Nut 116 zur Aufnahme einer Dichtraupe (Schaumdichtraupe) ausgebildet. Auf dem Vorsprung findet sich wiederum eine Erhebung 121 mit der Kontaktbohrungen 113, die in eine in der Ausnehmung ausgebildete weitere Vertiefung 122 eingreift (vergleiche Fig. 4b und 4d).

Die Kontaktbohrungen 113 sind nach dem Zusammenfügen zwei benachbarter Busgehäuse 101 mit den Kontaktbohrungen 11 im Bereich der Abdeckseite deckungsgleich.

Dabei taucht der Vorsprung 114 in die Ausnehmung 115 der Abdeckseite. Die einzelnen Busgehäuse werden mit der Anschlusseinheit 200 an Bohrungen 117 und/oder 118 und/oder 119 an einer Unterlage festgeschraubt (hier nicht dargestellt), wobei die Bohrungen 117 und 119 im Bereich des Vorsprunges 114 und der Ausnehmung 115 ausgebildet sind und nach dem Aneinanderreihen der Busgehäuse 101 miteinander fluchten. Die einzelnen Busgehäuse 101 lassen sich nach dem Aneinanderreihen damit nur noch oben entnehmen. Es kann zudem immer nur das letzte Busgehäuse 101 der Reihe entnommen werden.

In die eingeschäumte Dichtung in der Kontur bzw. Nut 116 wird eine Gegenkontur 120 - siehe Fig. 4b - eingedrückt, um eine sichere Abdichtung der Busgehäuse 101 gegeneinander zu gewährleisten.

Die Kontur 124 auf der Oberseite dient der sicheren Abdichtung der Anschlusseinheit an der Grundmoduleinheit 100.

Die Buskontakte 102 liegen nur unter den Bohrungen, die mit 112 und 113 gekennzeichnet sind, erst beim Montieren der Anschlusseinheit wird der Bus vervollständigt.

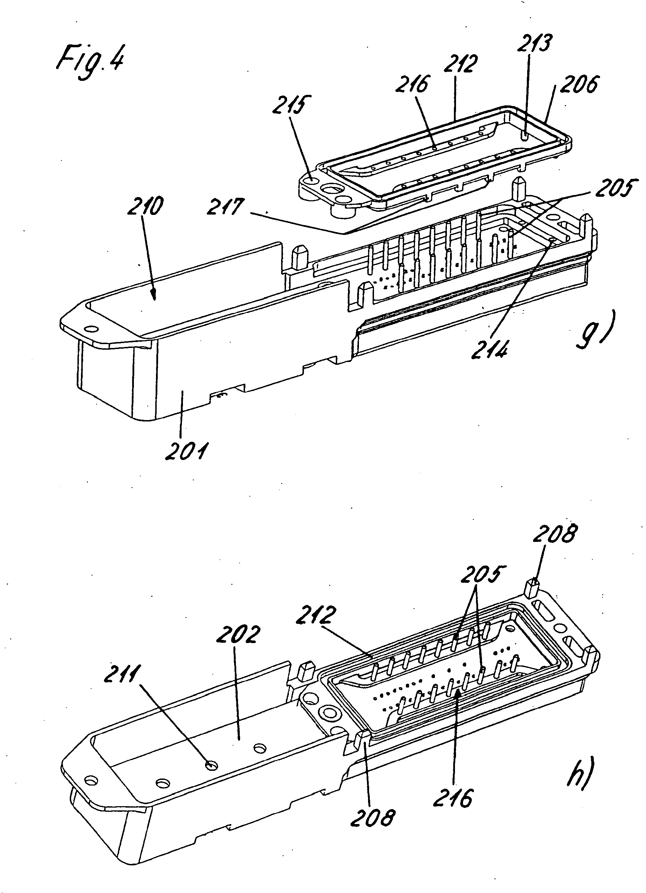

Nachfolgend sei näher die Montage der Anschlusseinheit 200 an der Grundmoduleinheit anhand Fig. 4g und h erläutert.

Das Anschlussgehäuse 201 der Anschlusseinheit ist an seiner zum Busgehäuse 101 gewandten Seite mit einer Ausnehmung 207 versehen, welche der Geometrie des Busgehäuses 101 angepasst ist und zu dessen Aufnahme dient. In die Ausnehmung 207 ragen die Kontaktstifte 205 hinein. Bei der Montage der Anschlusseinheit 200 auf dem Busgehäuse tauchen in die Ausnehmung 207 vorkragende Sucherstifte 208 am Anschlussgehäuse 201 in dafür vorgesehene aussparungsartige Konturen 123 am Busgehäuse 101, um ein sicheres Eintauchen der zwei zueinander parallelen Reihen von Kontaktstiften 205 in die dafür vorgesehenen Kontaktbohrungen 111, 112 zu gewährleisten und um die Anschlußeinheit 200 am Busgehäuse 101 festzuklemmen.

Die Busgehäuse 101 realisieren alleine noch keine Busweiterleitung sondern nur im Zusammenspiel mit den darauf aufgesetzten Anschlussgehäusen 201.

Anschließend werden noch die Basiseinheiten 303, die Elektronikleiterplatten 302 und die Abdeckungen 301 aufgesteckt - siehe Fig. 3a - und mit zwei Schrauben, welche fluchtende Bohrungen 304, 209 in der Abdeckung 301 und dem Anschlussgehäuse 201 durchsetzen, werden die Ein- /Ausgabemodule 300 und die Anschlußeinheiten 200 jeweils an den Bohrungen 118 mit den Busgehäusen 101 verschraubt und die Dichtungen mit dem nötigen Druck versehen, so dass das Modul als Einheit wasserdicht wird.

Die Anschlusseinheit 200 bzw. das Anschlussgehäuse 201 wird nach Fig. 4g und 4h gefertigt. Es wird in seinem hohlen Bereich bzw. an seiner Unterseite ebenfalls mit einer Vergussmasse ausgefüllt (hier nicht erkennbar).

So wird auch der Bereich 210, in dem sich die Anschlussstecker 204 (die Feldanschlüsse) befinden, vollständig befüllt, wobei Bohrungen 211in der Anschluss-Leiterplatte 202 das Füllen erleichtern.

Unter der Anschluss-Leiterplatte 202 ist eine Sperrwand ausgebildet, so dass in den Bereich des Steckverbinders 203 für die Elektronikleiterplatte 302 keine Vergussmasse laufen kann.

Ein Abdichten der Anschlusseinheit 200 zu den Busgehäusen 101 hin ermöglicht der Dichtrahmen 206. Dieser Dichtrahmen 206 mit einer im wesentlichen rechteckigen Kontur mit abgerundeten Ecken passt in die Ausnehmung 207 ein.

Er wird ebenfalls mit einer Schaumraupe in einer Nut 212 versehen. Sodann wird der komplette Dichtrahmen 206 in das Anschlussgehäuse in der Ausnehmung 207 gedrückt, wobei Stifte 213 am Dichtrahmen in Bohrungen 214 am Anschubgehäuse 201 tauchen und verklemmen.

Zusätzlich wird der Dichtrahmen 206 auf der den Stiften 213 gegenüberliegenden Bereich des Dichtrahmens durch zwei Schrauben in Bohrungen 215 auf das Anschlussbasis geschraubt und bietet so den nötigen Druck auf die Anschluss-Leiterplatte 202, um ein Durchlaufen der Vergussmasse in den Kontaktbereich des Anschlusssteckers 204 zu verhindern.

Die Kontaktstifte 205 durchsetzen Bohrungen 215 des Dichtrahmens 206 und werden so sehr gut geführt.

Nun kann das Anschlussgehäuse von unten mit Vergussmasse befüllt werden, wobei innerhalb des Dichtrahmens 206 nur eine Befüllung bis zum Niveau 216 der Bohrungen 215 erfolgt.

Der Dichtrahmen 206 weist an seiner Unterseite zusätzlich kleine Stelzen 217 auf, so daß er in der Ausnehmung 207 mit der Vergussmasse von unten komplett abgedichtet wird.

So wird die ganze Anschluss-Leiterplatte 202 mit Vergussmasse abgedeckt und der Bereich der Kontaktstifte 205 wird mit der Schaumdichtung des Dichtrahmens 206 abgedichtet.

Das Elektronikgehäuse 302 ist ebenfalls mit einer Schaumraupe versehen, um ein Abdichten zum Anschlussbasis zu gewährleisten.

Zusammengefasst erfolgt die Montage der Feldbusmodule 3 wie folgt:
1. Die Grundmoduleinheiten 100 werden an eine Unterlage wie eine Maschine angeschraubt (Bohrungen 117, 119), inkl. Endstück oder Busweiterleitung. Es gibt keine offenliegenden Dichtungen, die beschädigt werden könnten. Die Montage der nächsten Einheiten kann also auch am darauffolgenden Tag stattfinden.
2. Die Anschlusseinheit 200 wird auf die Grundmoduleinheit 100 aufgesetzt, wobei die Sucherstifte 208 in die Grundmoduleinheiten 110 tauchen, so dass die Anschlusseinheit 200 an der Grundmoduleinheit 100 sitzt und verklemmt ist.
3. Die Ein-/Ausgabemodule 300 werden aufgesteckt und mit zwei Schrauben jeweils durch die Anschlusseinheit 200 an den Bohrungen 118 in der Grundmoduleinheit 100 verschraubt. Damit sind alle Dichtungen fest auf die Gegenstücke gedrückt und verhindern ein Eindringen des Wassers. '

### Bezugszeichen

- elektrisches Gerät: 1
- Feldbusmodule: 3
- Gateway: 5
- Einspeisemodul: 7

- Grundmoduleinheit: 100
- Busgehäuse: 101
- Buskontakte: 102
- Busabdeckung: 103
- Stromschienenabschnitt: 104
- Kontaktfedern: 105
- Ausnehmung: 106
- Taschen: 107
- Auflageflächen: 108
- Bohrungen: 109
- Füllbereich: 110
- Kontaktbohrungen: 111, 112, 113
- Vorsprung: 114
- Ausnehmung: 115
- Nut: 116
- Bohrungen: 117, 118, 119
- Erhebung: 121
- Vertiefung: 122
- Kontur: 123
- Kontur: 124

- Anschlusseinheit: 200
- Anschlussgehäuse: 201
- Anschluss-Leiterplatte: 202
- Steckverbinder: 203
- Anschlüsse: 204, 204', 204"
- Kontaktstifte: 205
- Dichtrahmen: 206
- Ausnehmung: 207
- Sucherstifte: 208
- Bohrungen: 209
- Bereich: 210
- Bohrungen: 211
- Nut: 212
- Stifte: 213
- Bohrungen: 214
- Bohrungen: 215
- Niveau: 216
- Stelzen: 217

- Ein-/Ausgabemodul: 300
- Abdeckung: 301 (Modul-I/O-Cover)
- Elektronik(-Leiterplatte): 302 (Modul-I/O-PCB)
- Basiseinheit: 303 (Modul-I/O-Base)
- Bohrungen: 304

## Patentansprüche

1. Modul für ein elektrisches Gerät, insbesondere Feldbusmodul (3), das folgende Modulgruppen aufweist:
a) eine Grundmoduleinheit (100) zum Aufsetzen auf eine Unterlage wie eine Maschine oder dgl.;
b) eine auf die Grundmoduleinheit aufsetzbare Anschlusseinheit (200);
c) ein auf die Anschlusseinheit aufsetzbares Ein-/Ausgabemodul (300),
d) wobei die Grundmoduleinheit (100) breiter ist als die Anschlusseinheit und an einer Seitenkante der Busgehäuse (101) einen Vorsprung (114) und auf der gegenüberliegende Seitenkante der Busgehäuse (101) eine entsprechend ausgeformte Ausnehmung (115) aufweist, welche miteinander korrespondieren und abgedichtet beim Aneinanderreihen mehrerer Busgehäuse (101) zusammensteckbar sind, und
e) wobei die Grundmoduleinheit (100) das Busgehäuse nach Art einer Grundplatte (101), Buskontakte (102) und eine Busabdeckung 103 zur Abdeckung der Buskontakte (102) am Busgehäuse (101) aufweist, die vollständig mit einer dichtenden Vergussmasse abgedeckt ist, um das Eindringen von Feuchtigkeit in den Kontaktbereich zu verhindern.

2. Modul nach Anspruch 1, **dadurch gekennzeichnet, daß** die Anschlusseinheit (200) ein Anschlussgehäuse (201) aufweist, das eine Anschluss-Leiterplatte (202) aufnimmt, auf welcher ein Steckverbinder (203) zur Kontaktierung der Elektronikleiterplatte (302) und die Anschlussstecker (204) zum Anschluss externer Geräte wie Aktoren oder Sensoren angeordnet sind.

3. Modul nach Anspruch 1 oder 2, **dadurch gekennzeichnet, daß** das Ein-/Ausgabemodul 300 eine Abdeckung (301), eine Elektronik-Leiterplatte (302) und eine Basiseinheit (303) zur Aufnahme der Elektronikleiterplatte (302) aufweist.

4. Modul nach einem der vorstehenden Ansprüche; **dadurch gekennzeichnet, daß** sich die einzelnen Busgehäuse (101) nach dem Aneinanderreihen nur nach oben entnehmen lassen und daß nur das letzte Busgehäuse (101) aus einer Reihung entnehmbar ist.

5. Modul nach einem der vorstehenden Ansprüche, **dadurch gekennzeichnet, daß** auf dem Vorsprung (114) eine Erhebung (121) ausgebildet ist, welche eine Reihe von Kontaktbohrungen (113) aufweist, die in eine in der Ausnehmung ausgebildete weitere Vertiefung (122) eingreift.

6. Modul nach einem der vorstehenden Ansprüche, **dadurch gekennzeichnet, daß** die Kontaktbohrungen (113) nach dem Zusammenfügen zwei benachbarter Busgehäuse (101) mit den Kontaktbohrungen (111) im Bereich der Abdeckseite deckungsgleich sind.

7. Modul nach einem der vorstehenden Ansprüche, **dadurch gekennzeichnet, daß** auf der dem Steckverbinder (203) gegenüberliegenden Seite der Anschluss-Leiterplatte (302) zwei Reihen von Kontaktstiften (205) ausgebildet sind, welche in Einbauposition nach unten hin in Richtung der Grundmoduleinheit (100) vorstehen.

8. Modul nach einem der vorstehenden Ansprüche, **dadurch gekennzeichnet, daß** die Buskontakte (102) einen Stromschienenabschnitt (104) senkrecht von diesem nach oben abstehende Kontaktfedern (105) aufweisen.

9. Modul nach einem der vorstehenden Ansprüche, **dadurch gekennzeichnet, daß** die Buskontakte (102) in eine Ausnehmung (106) im Busgehäuse (101) eingesetzt sind, wobei die Kontaktfedern (105) in Taschen (107) der Ausnehmung (106) tauchen und bis zu Auflageflächen (108) an den Buskontakten (102) eingeschoben sind.

10. Modul nach einem der vorstehenden Ansprüche, **dadurch gekennzeichnet, daß** an der Busabdeckung (103) Stifte ausgebildet sind, welche in Bohrungen (109) des Busgehäuses festklemmbar sind und daß die Busabdeckung (103) an der Unterseite der Busgehäuse (101) ausgebildet ist und daß an der gegenüberliegenden Seite der Busgehäuse (101) drei Reihen parallel zueinander ausgerichteter Reihen von Kontakten (111, 112, 113) ausgebildet sind.

11. Modul nach einem der vorstehenden Ansprüche, **dadurch gekennzeichnet, daß** unterhalb von zwei Reihen der Kontaktbohrungen, den Kontaktbohrungsreihen mit den Kontakten (112, 113) die Federkontakte (105) der Buskontakte (102) liegen.

12. Modul nach einem der vorstehenden Ansprüche, **dadurch gekennzeichnet, daß** zumindest eine Reihe der Kontaktbohrungen (111, 112, 113) von einer Nut (116) umgeben ist, in welche eine Dichtraupe zur Abdichtung gegen ein benachbartes Busgehäuse (101), wobei in die Dichtraupe in der Nut (116) eine Gegenkontur (120) eines benachbarten Busgehäuses (101) eingreift.

13. Modul nach einem der vorstehenden Ansprüche oder nach dem Oberbegriff des Anspruchs 1, **dadurch gekennzeichnet, daß** ein mit Vergussmasse vergossener Dichtrahmen (206), die Kontaktstifte (205) durchsetzen, die Anschlusseinheit (200) dichtend nach unten hin zur Grundmoduleinheit (100) hin abschließt.

14. Modul nach einem der vorstehenden Ansprüche, **dadurch gekennzeichnet, daß** das Anschlussgehäuse (201) der Anschlusseinheit (200) an seiner zum Busgehäuse (101) gewandten Seite mit einer Ausnehmung (207) versehen ist, welche der Geometrie des Busgehäuses (101) angepasst ist und zu dessen Aufnahme dient, wobei in die Ausnehmung (207) die Kontaktstifte (205) und Sucherstifte (208) ragen, welche zum Eingriff in aussparungsartige Konturen (123) am Busgehäuse (101) vorgesehen sind.

15. Modul nach einem der vorstehenden Ansprüche, **dadurch gekennzeichnet, daß** die Anschlußeinheit (200) in ihrem hohlen Bereich weitgehend mit einer Vergußmasse ausgefüllt ist.

16. Modul nach einem der vorstehenden Ansprüche, **dadurch gekennzeichnet, daß** der Dichtrahmen (206) eine im wesentlichen rechteckige Kontur aufweist, in die Ausnehmung (207) einpasst und eine Nut (212) aufweist, welche mit einer Schaumraupe versehbar ist.

17. Modul nach einem der vorstehenden Ansprüche, **dadurch gekennzeichnet, daß** Stifte (213) am Dichtrahmen in Bohrungen (214) am Anschlußgehäuse (201) eintauchen und dort verklemmbar sind.

18. Modul nach einem der vorstehenden Ansprüche, **dadurch gekennzeichnet, daß** die Kontaktstifte (205) Bohrungen (215) des Dichtrahmens (206) durchsetzen, wobei das Anschlußgehäuse bis auf das Niveau (216) der Bohrungen (215) des Dichtrahmens (206) mit der Vergußmasse befüllt ist, wobei der Dichtrahmen (206) an seiner Unterseite Stelzen (217) aufweist, so daß er in der Ausnehmung (207) von unten vollständig mit Vergußmasse abgedichtet ist.

19. Modul, insbesondere nach einem der vorstehenden Ansprüche, **dadurch gekennzeichnet, daß** die Grundmoduleinheiten an eine Unterlage angeschraubt sind, und daß auf die Grundmoduleinheit (100) die Anschlußeinheiten aufgesetzt, insbesondere geklemmt sind, und daß die Ein-/Ausgabemodule (300) durch die Anschlußeinheiten (200) in der Grundmoduleinheit (100) verschraubt sind.

20. Modul nach einem der vorstehenden Ansprüche, **dadurch gekennzeichnet; daß** zwischen der Grundmoduleinheit, der Anschlußeinheit (200) und den Ein-/Ausgabemodulen (300) jeweils Dichtraupen ausgebildet sind.

## Claims

1. Module for an electric device, in particular a field bus module (3), which comprises the following module groups:
a) a basic module unit (100) for positioning onto a support such as a machine or the like;
b) a connector unit (200) that can be positioned on the basic module unit;
c) an input/output module (300) that can be put on the connector unit;
d) such that the basic module unit (100) is wider than the connector unit and comprises on one side edge of the bus housing (101) a projection (114) and on the opposite side edge of the bus housing (101) a correspondingly shaped recess (115), which fit one another and can be plugged together and sealed when a plurality of bus housings (101) are aligned with one another, and
e) such that the basic module unit (100) comprises the bus housing in the manner of a baseplate (101), bus contacts (102) and a bus cover (103) to cover the bus contacts (102) on the bus housing (101), which is covered completely with a sealing compound to prevent moisture from penetrating into the contact area.

2. Module according to Claim 1, **characterised in that** the connector unit (200) has a connector housing (201), which holds a connector printed circuit (202) on which is arranged a plug connector (203) for contacting the electronic printed circuit (302) and the connecting plug (204) for connecting external devices such as actors or sensors.

3. Module according to Claims 1 or 2, **characterised in that** the input/output module (300) comprises a cover (301), an electronic printed circuit (302) and a base unit (303) for holding the electronic printed circuit (302).

4. Module according to any of the preceding claims, **characterised in that** the individual bus housings (101), once lined up, can only be removed from above, and only the last bus housing (101) can be removed from a row.

5. Module according to any of the preceding claims, **characterised in that** an elevation (121) is formed on the projection (114), which has a row of contact bores (113), which engages in a further recess (122) formed in the recess.

6. Module according to any of the preceding claims, **characterised in that** when two adjacent bus housings (101) are joined together, the contact bores (113) coincide with the contact bores (111) in the area of the cover side.

7. Module according to any of the preceding claims, **characterised in that** on the side of the contact printed circuit (302) opposite the plug connector (203) are formed two rows of contact pins (205), which in the assembled position project downwards in the direction of the basic module unit (100).

8. Module according to any of the preceding claims, **characterised in that** the bus contacts (102) of a current rail section (104) have contact springs (105) extending perpendicularly upwards therefrom.

9. Module according to any of the preceding claims, **characterised in that** the bus contacts (102) are inside a recess (106) in the bus housing (101), and the contact springs (105) extend into pockets (107) of the recess (106) and are pushed in as far as contact surface (108) on the bus contacts (102).

10. Module according to any of the preceding claims, **characterised in that** pins are formed on the bus cover (103), which can be held firmly in bores (109) of the bus housing, and the bus cover (103) is formed on the underside of the bus housing (101), and three rows (111, 112, 113) of contacts directed parallel to one another are formed on the opposite side of the bus housing (101).

11. Module according to any of the preceding claims. **characterised in that** under two rows of contact bores, the contact bore rows with the contacts (112, 113), are the spring contacts (105) of the bus contacts (102).

12. Module according to any of the preceding claims, **characterised in that** at least one row of contact bores (111, 112, 113) is surrounded by a groove (116) in which a sealing strip is inserted for sealing relative to an adjacent bus housing (101), such that a counter-contour (120) of an adjacent bus housing (101) engages in the sealing strip in the groove (116).

13. Module according to any of the preceding claims or according to the precharacterising portion of Claim 1, **characterised in that** a sealing frame (206) filled with sealing compound, through which the contact pins (205) pass, closes off and seals the connector unit (200) from underneath relative to the basic module unit (100).

14. according to any of the preceding claims, **characterised in that** on its side facing towards the bus housing (101), the contactor housing (201) of the contactor unit (200) is provided with a recess (207) which is adapted to the geometry of the bus housing (101) and serves to hold it, and the contact pins (205) and locating pins (208) provided for engaging in recess-like contours (123) on the bus housing (101) project into the said recess (207).

15. Module according to any of the preceding claims, **characterised in that** in its hollow area the connector unit (200) is substantially filled with a sealing compound.

16. Module according to any of the preceding claims, **characterised in that** the sealing frame (206) has an essentially rectangular contour, fits into the recess (207), and has a groove (212) which can be provided with a foam strip.

17. Module according to any of the preceding claims, **characterised in that** pins (213) on the sealing frame extend into bores (216) in the connector housing (201) and can be held firmly therein.

18. Module according to any of the preceding claims, **characterised in that** the contact pins (205) pass through bores (215) in the sealing frame (206), the connector housing is filled with sealing compound up to the level (216) of the bores (215) in the sealing frame (206), and on its underside the sealing frame (206) has stilts (217) so that in the recess (207) it is sealed completely at the bottom with sealing compound.

19. Module, in particular according to any of the preceding claims, **characterised in that** the basic module units are screwed onto a support, and the connector units are positioned, in particular locked onto the basic module units (100), and the input/output modules (300) are screwed into the basic module units (100) through the connector units (200).

20. Module according to any of the preceding claims, **characterised in that** sealing strips are formed, in each case between the basic module unit, the connector unit (200) and the input/output modules (300).

## Revendications

1. Module pour un appareil électrique, en particulier un module de bus de terrain (3), présentant les groupes de modules suivants :
a) une unité de module de base (100) à poser sur un support, comme une machine ou similaires ;
b) une unité de connexion (200) pouvant être posée sur l'unité de module de base ;
c) un module d'entrée/sortie (300) pouvant être posé sur l'unité de connexion ;
d) dans lequel l'unité de module de base (100) est plus large que l'unité de connexion et présente sur un bord latéral du boîtier de bus (101) une saillie (114) et sur le bord latéral opposé du boîtier de bus (101) un creux (115) façonné de façon adéquate, qui correspondent l'une à l'autre et s'emboîtent de façon étanche lorsque plusieurs boîtiers de bus (101) sont juxtaposés, et
e) dans lequel l'unité de module de base (100) présente le boîtier de bus à la manière d'une plaque de base (101), des contacts de bus (102) et un couvercle de bus (103) pour recouvrir les contacts de bus (102) sur le boîtier de bus (101), qui est recouvert complètement d'une masse de scellement étanche afin d'empêcher la pénétration d'humidité dans la zone de contact.

2. Module selon la revendication 1, **caractérisé en ce que** l'unité de connexion (200) présente un boîtier de connexion (201) recevant une carte de circuits imprimés de connexion (202) sur laquelle sont disposés un connecteur enfichable (203) pour établir le contact avec la carte de circuits imprimés électroniques (302) et les connecteurs de connexion (204) pour connecter des appareils externes, tels que des actionneurs ou des capteurs.

3. Module selon la revendication 1 ou 2, **caractérisé en ce que** le module d'entrée/sortie (300) présente un couvercle (301), une carte de circuits imprimés électroniques (302) et une unité de base (303) pour recevoir la carte de circuits imprimés électroniques (302).

4. Module selon l'une quelconque des revendications précédentes, **caractérisé en ce qu'**après la juxtaposition, les boîtiers de bus (101) individuels peuvent être retirés uniquement vers le haut, et **en ce que** seul le dernier boîtier de bus (101) peut être retiré d'une rangée.

5. Module selon l'une quelconque des revendications précédentes, **caractérisé en ce que** sur la saillie (114) un bossage (121) est réalisé qui présente une rangée d'alésages de contact (113) s'engageant dans un autre creux (122) réalisé dans ledit creux.

6. Module selon l'une quelconque des revendications précédentes, **caractérisé en ce qu'**après l'assemblage de deux boîtiers de bus (101) voisins, les alésages de contact (113) coïncident avec les alésages de contact (111) au niveau de la face de recouvrement.

7. Module selon l'une quelconque des revendications précédentes, **caractérisé en ce que** du côté de la carte de circuits imprimés (302) opposé au connecteur enfichable (203), deux rangées de fiches de contact (205) sont réalisées qui, dans la position de montage, font saillie vers le bas en direction de l'unité de module de base (100).

8. Module selon l'une quelconque des revendications précédentes, **caractérisé en ce que** les contacts de bus (102) présentent une portion de barre conductrice (104) perpendiculaire à des ressorts de contact (105) faisant saillie vers le haut.

9. Module selon l'une quelconque des revendications précédentes, **caractérisé en ce que** les contacts de bus (102) sont insérés dans un creux (106) dans le boîtier de bus (101), dans lequel les ressorts de contact (105) s'enfoncent dans des poches (107) du creux (106) et sont introduits jusqu'aux surfaces d'appui (108) sur les contacts de bus (102).

10. Module selon l'une quelconque des revendications précédentes, **caractérisé en ce que** sur le couvercle de bus (103), des fiches sont réalisées qui peuvent se bloquer dans des alésages (109) du boîtier de bus, et **en ce que** le recouvrement de bus (103) est réalisé sur la face inférieure du boîtier de bus (101), et **en ce que** du côté opposé du boîtier de bus (101), trois rangées de rangées de contacts (111, 112, 113) orientées en parallèle entre elles sont réalisées.

11. Module selon l'une quelconque des revendications précédentes, **caractérisé en ce qu'**au-dessous de deux rangées des alésages de contact, des rangées d'alésages de contact avec les contacts (112, 113), se trouvent les contacts à ressort (105) des contacts de bus (102).

12. Module selon l'une quelconque des revendications précédentes, **caractérisé en ce qu'**au moins une rangée des alésages de contact (111, 112, 113) est entourée d'une rainure (116) dans laquelle un bourrelet d'étanchéité s'engage pour assurer l'étanchéité par rapport à un boîtier de bus (101) voisin, dans lequel un contour complémentaire (120) d'un boîtier de bus (101) voisin s'engage dans le bourrelet d'étanchéité dans la rainure (116).

13. Module selon l'une quelconque des revendications précédentes ou selon le préambule de la revendication 1, **caractérisé en ce qu'**un cadre d'étanchéité (206) scellé avec une masse de scellement, traversé par les fiches de contact (205), termine l'unité de connexion (200) de façon étanche vers le bas en direction de l'unité de module de base (100).

14. Module selon l'une quelconque des revendications précédentes, **caractérisé en ce que** le boîtier de connexion (201) de l'unité de connexion (200) est muni sur son côté tourné vers le boîtier de bus (101) d'un creux (207) adapté à la géométrie du boîtier de bus (101) et servant à recevoir celui-ci, dans lequel les fiches de contact (205) et fiches de détection (208) font saillie dans le creux (207), les fiches étant prévues pour s'engager dans des contours (123) de type dégagement sur le boîtier de bus (101).

15. Module selon l'une quelconque des revendications précédentes, **caractérisé en ce que** l'unité de connexion (200) est dans sa partie creuse largement remplie d'une masse de scellement.

16. Module selon l'une quelconque des revendications précédentes, **caractérisé en ce que** le cadre d'étanchéité (206) présente un contour substantiellement rectangulaire, s'adapte dans le creux (207) et présente une rainure (212) qui peut être munie d'un bourrelet de mousse.

17. Module selon l'une quelconque des revendications précédentes, **caractérisé en ce que** des fiches (213) sur le cadre d'étanchéité s'enfoncent dans des alésages (214) sur le boîtier de connexion (201) et peuvent y être bloquées.

18. Module selon l'une quelconque des revendications précédentes, **caractérisé en ce que** les fiches de contact (205) traversent des alésages (215) du cadre d'étanchéité (206), dans lequel le boîtier de connexion est rempli jusqu'au niveau (216) des alésages (215) du cadre d'étanchéité (206) avec la masse de scellement, dans lequel le cadre d'étanchéité (206) présente sur sa face inférieure des appuis (217) de sorte qu'il est rendu étanche dans le creux (207) par le bas complètement avec une masse de scellement.

19. Module, en particulier selon l'une quelconque des revendications précédentes, **caractérisé en ce que** les unités de module de base sont vissées sur un support, et **en ce que** les unités de connexion sont posées, en particulier serrées, sur l'unité de module de base (100), et **en ce que** les modules d'entrée/sortie (300) sont vissées dans l'unité de module de base (100) à travers les unités de connexion (200).

20. Module selon l'une quelconque des revendications précédentes, **caractérisé en ce qu'**entre l'unité de module de base, l'unité de connexion (200) et les modules d'entrée/sortie (300), respectivement des bourrelets d'étanchéité sont réalisés.
